# EUROPÄISCHE PATENTANMELDUNG

(11) **EP 2 887 006 A2**
(43) Veröffentlichungstag der Anmeldung: **24.06.2015**
(21) Anmeldenummer: 14003827.4
(22) Anmeldetag: 13.11.2014
(51) Int. Cl.: F42C 15/29, F42C 11/00

(54) **Zünder eines Flugkörpers**

(30) Priorität: 21.12.2013 DE 102013021848
(71) Anmelder: JUNGHANS Microtec GmbH, 78655 Dunningen-Seedorf (DE); Diehl & Eagle Picher GmbH, 90552 Röthenbach (DE)
(72) Erfinder: Hüttner, Robert, DE - 21398 Neetze (DE); Wich, Harald, DE - 91207 Lauf (DE)
(74) Vertreter: Diehl Patentabteilung

(57) **Zusammenfassung**

Die Erfindung geht aus von einem Zünder (8, 70) eines Flugkörpers (2) mit einem Energieversorgungssystem (12, 68), dass eine Energieversorgungseinheit (20) mit zumindest einer Heißseite (36), zumindest einer Kaltseite (40) und zumindest einem zwischen den Seiten angeordneten Thermogenerator (22) aufweist.

Um eine zügige und zuverlässige Stromerzeugung für elektrische Einheiten (10) des Zünders (8) zu erreichen, wird vorgeschlagen, dass die Energieversorgungseinheit (20) an ihrer zumindest einen Heißseite (36) eine Pyroeinheit (30, 72) zum Erzeugen von Wärme durch einen Verbrennungsprozess umfasst.

## Beschreibung

Die Erfindung betrifft einen Zünder eines Flugkörpers mit einem Energieversorgungssystem, das eine Energieversorgungseinheit mit zumindest einer Heißseite, zumindest einer Kaltseite und zumindest einen zwischen den Seiten angeordneten Thermogenerator aufweist.

Zünder von größeren Geschossen haben üblicherweise elektrische beziehungsweise elektronische Bauelemente zur Steuerung verschiedener Vorgänge, beispielsweise eine Sicherungsfunktion, eine Zündfunktion, eine Messfunktion, wie eine Entfernungsmessfunktion und dergleichen. Zur Versorgung der elektrischen Elemente mit Betriebsenergie ist es bekannt, Zünder mit Batterien auszustatten, die die notwendige Betriebsspannung liefern. Solche Batterien müssen jedoch über einen sehr langen Zeitraum absolut zuverlässig lagerfähig sein, sodass auf sehr hochwertige und teure Batterien zurückgegriffen werden muss. Außerdem weisen Batterien ein relativ geringes Verhältnis von Energieinhalt zu Gewicht auf, sodass sie einen großen Bauraum innerhalb des Zünders einnehmen.

Zur Lösung dieses Problems ist es bekannt, einen Zünder mit einer Energieversorgungseinheit auszustatten, die eine Wärmequelle des Geschosses zur Stromerzeugung mittels des thermoelektrischen Effekts ausnutzt. Ein solcher Zünder ist aus der DE 3100506 A1 bekannt. Als Wärmequelle werden vordere Bereiche des Geschosses verwendet, die sich im Flug deutlich aufheizen. Alternativ wird der durch den Abschuss aufgeheizte hintere Bereich des Geschosses oder Wärme aus einem Leuchtspur-Element genutzt.

Es ist eine Aufgabe der vorliegenden Erfindung, einen Zünder eines Flugkörpers anzugeben, dessen elektrische Elemente zuverlässig mit Strom versorgt werden können.

Diese Aufgabe wird durch einen Zünder der eingangs genannten Art gelöst, bei dem erfindungsgemäß die Energieversorgungseinheit an ihrer zumindest einen Heißseite eine Pyroeinheit zum Erzeugen von Wärme durch einen Verbrennungsprozess umfasst.

Die Erfindung geht von der Überlegung aus, dass es beim Ausnutzen der Reibungswärme an der Vorderseite des Flugkörpers eine Weile braucht, bis genügend Wärme zum Erzeugen der Betriebsspannung der elektrischen Elemente zur Verfügung steht. Außerdem besteht das Risiko, dass die durch Reibung entstehende Wärme - je nach Schusssituation - nicht ausreichend ist. Mit einer Pyroeinheit steht sehr zügig nach Zündung ausreichend Wärme zur genügenden Stromerzeugung zur Verfügung. Außerdem weisen Pyroeinheiten in der Regel eine sehr hohe Energiedichte auf, sodass sie sehr kompakt hergestellt werden können und nur einen geringen Bauraum im Zünder benötigen.

Der Flugkörper kann ein Lenkflugkörper mit einem Raketentriebwerk und insbesondere einem Suchkopf sein oder ein Geschoss zum Verschießen aus einem Rohr, wie eine Granate, ein Artilleriegeschoss oder dergleichen. Das Geschoss kann ein drallfreies Geschoss oder ein Geschoss für einen drallbehafteten Flug sein. Vorteilhaft sind auch selbstlenkende Geschosse mit einem Suchkopf und einer Lenkeinheit zum Steuern eines Flugs des Geschosses. Das Energieversorgungssystem dient zum Versorgen von elektrischen Elementen des Flugkörpers mit Betriebsenergie. Unter elektrischen Elementen werden auch elektronische Elemente verstanden. Die elektrischen Elemente können Elemente eines Suchkopfs, einer Lenkeinheit und/oder eines Zünders sein, wobei zweckmäßigerweise sämtliche Elemente einer solchen Einheit mit Betriebsenergie aus dem Energieversorgungssystem gespeist werden.

Die Energieversorgungseinheit ist eine Einheit zum Erzeugen von elektrischer Energie aus einer Temperaturdifferenz. Hierzu kann sie einen oder mehrere Thermogeneratoren mit jeweils einem oder mehreren Generatorelementen aufweisen. Bei dem Generatorelement kann es sich beispielsweise um ein Peltierelement handeln. Ein Peltierelement umfasst zumindest ein p-dotiertes und ein n-dotiertes, insbesondere quaderförmiges Halbleiter-Element, wobei die unterschiedlich dotierten HalbleiterElemente abwechselnd oben und unten durch elektrisch leitende Verbinder verbunden sind, so dass Strom z. B. erst das p-dotierte und dann das n-dotierte Halbleiter-Element usw. durchfließt. Ein Thermogenerator erzeugt Spannung - und in Verbindung mit einem Verbraucher bzw. Stromkreis Strom - bei Vorliegen einer Temperaturdifferenz zwischen der Heißseite und der Kaltseite. Die Energieversorgungseinheit kann mehrere Heißseiten und Kaltseiten aufweisen, je nach Anzahl der vorhandenen Thermogeneratoren. Hierbei weist zweckmäßigerweise jeder Thermogenerator einer Heißseite und eine Kaltseite der Energieversorgungseinheit auf. Bei Vorhandensein von mehreren Thermogeneratoren können diese elektrisch in Reihe oder parallel geschaltet sein. Sie erzeugen entweder gemeinsam oder jeweils alleine die Betriebsspannung und die Betriebsenergie, die zumindest ein elektrisches Element des Flugkörpers für seinen Betrieb benötigt.

Die Pyroeinheit ist eine durch Verbrennung Wärme erzeugende Einheit. Sie ist ein Teil der Energieversorgungseinheit und wird zweckmäßigerweise von einem Gehäuse des Zünders, insbesondere der Energieversorgungseinheit, umgeben, insbesondere an allen Seiten. Die Pyroeinheit dient zweckmäßigerweise überwiegend, insbesondere ausschließlich, der Stromerzeugung. Sie umfasst ein Brennelement, mit z.B. einem Festbrennstoff, das beim Verbrennungsprozess Wärme freisetzt. Die Pyroeinheit ist so ausgeführt, dass zumindest 10 %, insbesondere der überwiegende Teil der im Verbrennungsprozess erzeugten Wärme dem oder den Thermogeneratoren der Energieversorgungseinheit beim Betrieb des Zünders zugeführt wird.

In einer vorteilhaften Ausführungsform der Erfindung weist die Energieversorgungseinheit zwei Thermogeneratoren auf und die Pyroeinheit ist zwischen den Thermogeneratoren angeordnet. Die Wärmeenergie kann beidseitig von der Pyroeinheit zur thermoelektrischen Nutzung abgeführt werden, sodass eine gute Energieausbeute erreicht werden kann. Zweckmäßigerweise sind die Thermogeneratoren symmetrisch zueinander angeordnet, wobei die Pyroeinheit eine Symmetrieebene der beiden Thermogeneratoren zueinander bilden kann. Durch eine spiegelbildliche beidseitige Anordnung an der Pyroeinheit kann eine gleichmäßige Wärmebelastung der Thermogeneratoren erreicht werden. Die Kaltseiten der beiden Thermogeneratoren können in entgegengesetzte Richtungen gewandt und zweckmäßigerweise jeweils abgewandt von der Pyroeinheit angeordnet sein. Um eine gleichmäßige mechanische Belastung der Thermogeneratoren zu erreichen, ist die Symmetrie senkrecht zur Axialrichtung des Zünders beziehungsweise Flugkörpers ausgerichtet.

Eine weitere vorteilhafte Ausführungsform der Erfindung sieht vor, dass die Pyroeinheit ein Brennelement aufweist, das zumindest im Wesentlichen als ebene Platte ausgeführt ist. Hierdurch kann eine gute Wärmeverteilung in der Energieversorgungseinheit erreicht werden. Die Platte ist zweckmäßigerweise eine kreisförmige Scheibe mit ihrem Mittelpunkt in der Flugkörperachse. Das Brennelement kann aus Festbrennstoff bestehen.

Während des Verbrennungsprozesses entsteht die zur Stromerzeugung benötigte Wärme in sehr kurzer Zeit. Nach dem Verbrennungsprozess kühlt die Pyroeinheit wieder ab, sodass die Wärme nur für eine Weile zur Verfügung steht. Um möglichst lange Strom erzeugen zu können, ist es vorteilhaft, wenn zwischen dem zumindest einen Thermogenerator der Energieversorgungseinheit und der Pyroeinheit ein Wärmespeicher angeordnet ist. Diesem kann Verbrennungswärme zugeführt werden, die im Wärmespeicher gespeichert und anschließend wieder abgegeben wird. Je nach Beschaffenheit des Wärmespeichers kann eine schnelle oder langsamere Wärmeabgabe eingestellt werden, sodass die Wärmeabgabe an die gewünschte Stromerzeugungszeitdauer angepasst werden kann. Der Wärmespeicher ist zweckmäßigerweise ein Festkörperspeicher, der auch im maximal erhitzen Zustand ein Festkörper bleibt. Vorteilhaft ist ein Wärmespeicher mit einer Wärmekapazität im Bereich von Metallen, wobei ein metallischer Wärmespeicher vorteilhaft ist, insbesondere aus zumindest überwiegend Kupfer, Aluminium oder Stahl. Wärmespeicher und Pyroeinheit sind zweckmäßigerweise so zueinander angeordnet und dimensioniert, dass der Wärmespeicher den überwiegenden Teil der pyrotechnisch erzeugten Wärme aufnimmt.

Die Wärmespeicherung kann weiter verbessert werden, wenn zwei Wärmespeicher beidseitig um die Pyroeinheit angeordnet sind. Vorteilhaft ist eine symmetrische Anordnung zueinander. Ebenfalls vorteilhaft ist eine Plattenform des Wärmespeichers, insbesondere bei der die Ausdehnung in der Dickenrichtung maximal 20 % der Ausdehnung in die beiden Richtungen senkrecht dazu beträgt. Wärmespeicher und Pyroeinheit können hierbei jeweils als Platte ausgeführt sein und insbesondere eine Sandwichstruktur bilden.

Um zu einem schnellen Start der Stromerzeugung zu kommen, muss dem zumindest einen Thermogenerator schnell Wärme aus dem Verbrennungsprozess übertragen werden. Während die Verbrennung in der Regel sehr schnell vonstatten geht und auch das oder die Generatorelemente des Thermogenerators schnell auf Wärme ansprechen, kann der Wärmetransfer durch den Wärmespeicher eine relativ große Zeitspanne in Anspruch nehmen, bis genügend Wärme den Thermogenerator erreicht. Um die Wärmetransferzeit zu verkürzen, ist es vorteilhaft, wenn die Dicke des Wärmespeichers in Wärmeausbreitungsrichtung variiert. Je dünner der Wärmespeicher ist, desto schneller geht der Wärmetransfer von dessen Heißseite zu dessen Kaltseite vonstatten. An den dickeren Stellen kann jedoch mehr Wärme gespeichert werden. Auf diese Weise kann ein guter Kompromiss zwischen schnellem Wärmetransfer und guter Speicherleistung erreicht werden. Die Wärmeausbreitungsrichtung ist hierbei die Richtung von der Pyroeinheit zu einem Thermogenerator, insbesondere die Richtung der kürzesten Entfernung.

Vorteilhafterweise ist der Wärmespeicher, z.B. eine Platte, insbesondere eine Metallplatte, auf seiner der Pyroeinheit zugewandten Seite mit Ausnehmungen versehen. Hierdurch kann eine gute Dickenvariation des Wärmespeichers erreicht werden. Zweckmäßigerweise reduzieren die Ausnehmungen einen Wärmetransferweg durch den Wärmespeicher um zumindest 50 % relativ zu einem durchschnittlichen Wärmetransferweg eines Abschnitts des Wärmespeichers zwischen den Ausnehmungen. Der Wärmespeicher ist also im Bereich der Ausnehmungen maximal halb so dick wie zwischen den Ausnehmungen in Bezug zu einem direkten Weg von der Pyroeinheit zu einem Thermogenerator. Die Ausnehmungen können mit Brennstoff gefüllt sein.

Um einen zügigen Wärmeübertrag vom Wärmespeicher auf den zumindest einen Thermogenerator und damit eine zügige Stromversorgung der elektrischen Elemente des Zünders zu erzielen, wird vorgeschlagen, dass das oder die Generatorelemente des zumindest einen Thermogenerators an Zonen gegenüber von den Ausnehmungen am Wärmespeicher angeordnet sind. Durch die Anordnung eines Generatorelements im Bereich einer Zone gegenüber einer Ausnehmung im Wärmespeicher ist ein schneller Wärmetransfer auf das Generatorelement möglich. Wenn es sich bei den Generatorelementen um Peltierelemente handelt, ist es auch möglich, die Ausnehmungen im Wärmespeicher so zu setzen bzw. so anzuordnen, dass sie auf der der Pyroeinheit zugewandten Seite so liegen, dass die jeweils gegenüberliegenden Zonen jeweils zwischen p-dotiertem Halbleiter-Element und n-dotiertem Halbleiter-Element eines Peltierelements liegen, insbesondere mittig zwischen ihnen.

Einerseits ist es vorteilhaft, einen Wärmespeicher möglichst gering zu dimensionieren, um Platz und Gewicht im Zünder einzusparen. Andererseits muss der Wärmespeicher genügend Energie speichern können, damit elektrische Energie während einer gewünschten Zeitspanne erzeugt werden kann. Je heißer der Wärmespeicher aufgeheizt wird, desto größer ist die gespeicherte Wärmemenge. Eine Temperaturobergrenze wird jedoch durch das oder die Generatorelemente des Thermogenerators festgelegt, die oberhalb einer Grenztemperatur zerstört werden. Bei mit Weichlot gelöteten Generatorelementen liegen solche Grenztemperaturen in der Regel um die 200 °C. Um eine gute Wärmespeicherung zu erreichen, wird jedoch vorgeschlagen, dass die Pyroeinheit und der Wärmespeicher so dimensioniert sind, dass der Wärmespeicher an seiner Kaltseite nach Zünden der Pyroeinheit im regulären Betrieb zumindest kurzfristig bis über eine Lotschmelztemperatur, z.B. auf zumindest 300 °C, erhitzt wird. Die Generatorelemente können kurzfristig einer solchen Temperatur standhalten, sodass eine kurzfristige Überhitzung der Generatorelemente akzeptabel ist. Ein Lot zwischen einem Generatorelement und einem damit verbundenen Element, z.B. einem Stromverbinder oder einer anderen Haltestruktur, kann zwar schmelzen, doch das kann nach dem Abschuss bzw. während des Flugs tolerierbar sein, wenn das Generatorelement anderweitig gehalten ist, z.B. durch eine Einklemmung zwischen zwei Elementen. Insofern ist es hinsichtlich der Erzeugung von möglichst viel elektrischer Energie vorteilhaft, wenn die Pyroeinheit und der Wärmespeicher so dimensioniert sind, dass der Wärmespeicher an seiner Kaltseite nach Zünden der Pyroeinheit im regulären Betrieb zumindest kurzfristig bis auf eine Temperatur erhitzt wird, bei der eine Lotverbindung an einem Generatorelement schmilzt. Die Kaltseite ist einem Thermogenerator zugewandt. Die Temperatur bzw. der konkrete Wert von 300 °C ist dort zu verstehen, wo der Thermogenerator direkt am Wärmespeicher anliegt, sodass dieser auf die Temperatur bzw. 300 °C aufgeheizt wird.

Üblicherweise sind Generatorelemente, wie beispielsweise Peltierelemente, beidseitig zwischen Stromverbindern angeordnet, die jeweils mit dem entsprechenden Generatorelement verlötet sind. Im Fall von Peltierelementen sind das p- und n-dotierte Halbleiter-Elements eines Peltierelements auf einer Seite über einen Stromverbinder miteinander verbunden und auf der anderen Seite ist das n-dotierte Halbleiter-Element mit dem p-dotierten Halbleiterelement des nächsten Peltierelements über einen Stromverbinder verbunden usw., so dass Strom nacheinander p- und n-dotiertes Halbleiter-Element des ersten Peltierelements und dann des nächsten Peltierelements durchfließt. Bei einer Temperatur deutlich oberhalb 200 °C schmilzt das Lot und der Thermogenerator zerfällt. Um die Generatorelemente auch bei einer kurzzeitigen Überhitzung stabil an ihrem Platz zwischen den Stromverbindern zu halten, wird vorgeschlagen, dass sie beidseitig zwischen den Stromverbindern eingeklemmt sind. Durch einen zweiseitigen Druck auf ein Generatorelement kann dieses auch bei einem Aufschmelzen des verbindenden Lots kurzzeitig stabil positioniert bleiben. Durch den Druck besteht noch genügend Halt hierfür.

Beim Abschuss wird ein Geschoss mit einer Beschleunigung von mehreren 10.000 g beaufschlagt. Beschleunigungen bis zu 100.000 g sind möglich. Entsprechend schockfest ist der Zünder zu konstruieren. Um einem Defekt der Energieversorgungseinheit entgegenzuwirken, wird vorgeschlagen, dass der zumindest eine Thermogenerator ein oder mehrere Generatorelemente aufweist, die in einer Haltestruktur mit einem Haltematerial vergossen sind. Das Haltematerial kann Kunstharz oder ein anderer Kunststoff sein, der elektrisch isolierend ist. Die Haltestruktur kann zwei Halteplatten aufweisen, die die Generatorelemente beidseitig halten.

Beim Betrieb der Energieversorgungseinheit nimmt diese durch den Verbrennungsprozess viel Wärme auf. Diese tritt auch auf die zumindest eine Kaltseite über, sodass eine Temperaturdifferenz gegebenenfalls zu schnell zu gering für eine ausreichende Strom- bzw. Spannungserzeugung werden kann. Um einem solchen Aufheizen der Kaltseite entgegenzuwirken, ist es vorteilhaft, an der zumindest einen Kaltseite einen Kältespeicher anzuordnen. Dieser ist zweckmäßigerweise aus dem gleichen Material wie der Wärmespeicher, beispielsweise aus Kupfer. Eine gute Wärmeabgabe aus dem Kältespeicher kann erreicht werden, wenn dieser insbesondere unmittelbar an einer metallischen Flugkörper-Außenwand angeordnet ist. Der Kältespeicher kann relativ lange kühl gehalten und der Stromerzeugungsprozess kann lange aufrechterhalten bleiben.

Alternativ ist es möglich, die Flugkörper-Außenwand unmittelbar als Kältespeicher zu verwenden. Insofern ist die Kaltseite dann unmittelbar an der Flugkörper-Außenwand angeordnet. Hierfür ist es vorteilhaft, wenn die Flugkörper-Außenwand im Bereich der Kaltseite dicker ausgeführt ist, als in der Umgebung.

Um eine Stromerzeugung möglichst schnell zu ermöglichen, ist es vorteilhaft, wenn der Brennstoff der Pyroeinheit eine geringe Durchbrenndauer aufweist. Hierbei sind maximal 2 % der Zeit vorteilhaft, die die Energieversorgungseinheit Strom zum Betrieb von elektrischen Elementen des Zünders bereitstellt.

Die Zündung der Pyroeinheit erfolgt zweckmäßigerweise mechanisch, da in der Regel keine elektrische Energie, beispielsweise für einen Glühdraht, zur Verfügung steht. Eine zuverlässige mechanische Zündung kann erreicht werden, wenn die Pyroeinheit einen Anzünder aufweist, der zu einer Anstichzündung bei Abschuss des Geschosses vorbereitet ist. Hierzu hat der Anzünder zweckmäßigerweise eine Zündladung, die durch ein Anstichelement gezündet wird. Die Zündladung zündet ihrerseits ein Brennelement der Pyroeinheit. Zur Zündung der Zündladung kann das Anstichelement durch die Abschussbeschleunigung auf die Zündladung beschleunigt werden und bei Auftreffen diese zünden, z.B. durch Friktion oder Aufschlag. Um ein ungewolltes Auftreffen des Anstichelements auf der Zündladung zu verhindern, ist dieses zweckmäßigerweise mit einem Arretierelement oder Halteelement gesichert. Dieses ist vorteilhafterweise so ausgeführt, dass es bei Abschuss durch die Abschussbeschleunigung abreißt, also bei einem für das Geschoss typischen Abschussbeschleunigungsverlauf, und so das Anstichelement zur Beschleunigung auf die Zündladung freigibt.

Ein schnelles Durchbrennen des Brennelements kann erreicht werden, wenn dieses von einer Mitte aus gezündet wird. Hierzu kann ein Zündfeuer der Zündladung auf die Mitte des Brennelements gerichtet werden. Nachteilig bei einer solchen Zündung ist jedoch ein relativ großer Aufbau, da die Zündladung oberhalb oder unterhalb des Brennelements positioniert werden muss. Der Bauraum kann gering gehalten werden, wenn eine radiale Anzündung des Brennelements erfolgt, also radial von außen. Hierzu ist der Anzünder zweckmäßigerweise zu einem radialen Anzünden des Pyroelements vorbereitet.

Um eine mechanische Anzündung zuverlässig zu erreichen, ist es außerdem vorteilhaft, wenn das Anzünden des Pyroelements mithilfe einer axialen Zündbeschleunigung eines Anstichelements erfolgt. Hierbei kann die Anstichrichtung von der Zündrichtung abweichen. Eine Richtungsänderung des Zündfeuers kann durch einen Kanal mit einer Umlenkung erreicht werden, die das Zündfeuer von einer axialen in eine radiale Richtung umlenkt. Alternativ weist die Zündladung bereits eine radiale Zündrichtung auf, auch wenn sie durch einen axialen Aufschlag gezündet wurde.

Die Erfindung ist außerdem gerichtet auf ein Verfahren zum Versorgen von elektrischen Elementen eines Zünders eines Flugkörpers mit elektrischer Energie, bei dem zumindest eine Heißseite einer Energieversorgungseinheit eines Energieversorgungssystems erwärmt wird, zumindest ein Thermogenerator der Energieversorgungseinheit Strom erzeugt und dieser zu den elektrischen Elementen geführt wird.

Um eine zügige und zuverlässige Stromerzeugung zu ermöglichen, wird vorgeschlagen, dass erfindungsgemäß zum Erwärmen der zumindest einen Heißseite ein Verbrennungsprozess einer Pyroeinheit der Energieversorgungseinheit ausgelöst wird.

Die bisher gegebene Beschreibung vorteilhafter Ausgestaltungen der Erfindung enthält zahlreiche Merkmale, die in den einzelnen Unteransprüchen teilweise zu mehreren zusammengefasst wiedergegeben sind. Diese Merkmale können jedoch zweckmäßigerweise auch einzeln betrachtet und zu sinnvollen weiteren Kombinationen zusammengefasst werden. Insbesondere sind diese Merkmale jeweils einzeln und in beliebiger geeigneter Kombination mit dem erfindungsgemäßen Verfahren und der erfindungsgemäßen Vorrichtung gemäß den unabhängigen Ansprüchen kombinierbar.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Die Ausführungsbeispiele dienen der Erläuterung der Erfindung und beschränken die Erfindung nicht auf die darin angegebene Kombination von Merkmalen, auch nicht in Bezug auf funktionale Merkmale. Außerdem können dazu geeignete Merkmale eines jeden Ausführungsbeispiels auch explizit isoliert betrachtet, aus einem Ausführungsbeispiel entfernt, in ein anderes Ausführungsbeispiel zu dessen Ergänzung eingebracht und/oder mit einem beliebigen der Ansprüche kombiniert werden.

Es zeigen:
- FIG 1: ein Artilleriegeschoss mit einem schematisch dargestellten Zünder mit einem Energieversorgungssystem,
- FIG 2: das Energieversorgungssystem in einer Seitendarstellung,
- FIG 3: einen Anzünder neben dem nur schematisch angedeuteten Energieversorgungssystem aus FIG 2,
- FIG 4: einen alternativen Anzünder und
- FIG 5: einen Ausschnitt aus einem weiteren Geschoss.

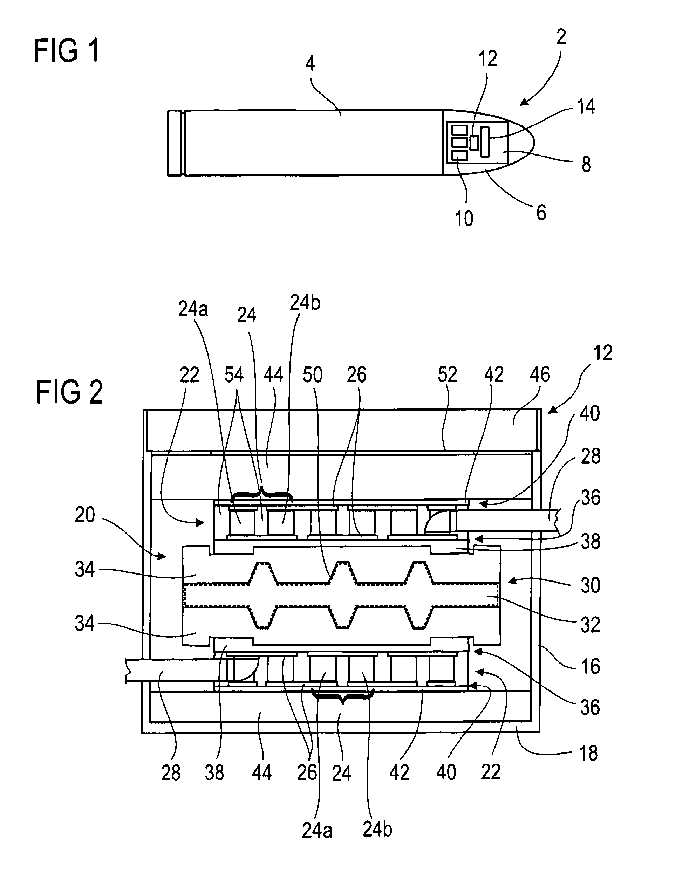

FIG 1 zeigt einen Flugkörper 2 in Form eines Artilleriegeschoss mit einem hinteren Wirkladungsteil 4 und einem vorderen Kopfteil 6, in dem ein Zünder 8 angeordnet ist. Der Zünder 8 ist in FIG 1 nur schematisch dargestellt und beherbergt eine Reihe von elektrischen Elementen 10, die während des Betriebs von einem Energieversorgungssystem 12 mit elektrischer Betriebsspannung versorgt werden. Die Elemente 10 sind beispielsweise Teil eines Suchkopfs des Flugkörpers 2, der zur Zielverfolgung und Lenkung des Flugkörpers 2 vorbereitet ist. Eine Steuereinheit 14 wird ebenfalls von dem Energieversorgungssystem 12 mit Betriebsspannung versorgt und steuert die elektrischen Elemente 10. Die Elemente 10 können ein Annäherungssensor, ein Infrarotsensor, ein Zeitzünder, ein Entfernungsmesser und dergleichen sein.

Das Energieversorgungssystem 12 ist in FIG 2 in einer Seitenansicht dargestellt, wobei dessen Gehäuse 16 nur angedeutet ist, sodass nur dessen Seitenwände und Boden 18 erkennbar ist. Das Energieversorgungssystem 12 umfasst eine Energieversorgungseinheit 20, die zwei Thermogeneratoren 22 umfasst. Jeder der beiden Thermogeneratoren 22 enthält eine Vielzahl von Generatorelementen 24, die in einem zweidimensionalen Gitter angeordnet und durch Stromverbinder 26 in Reihe geschaltet sind.

Die Generatorelemente 24 bestehen aus einem Halbleitermaterial mit einem p-n-Übergang und sind zur Ausnutzung des Seebeck-Effekts vorbereitet. Aus einer Temperaturdifferenz zwischen ihrer Heißseite und ihrer Kaltseite erzeugen sie elektrische Spannung, die auch im Betrieb der elektrischen Elemente 10 aufrechterhalten bleibt, wodurch ein Betriebsstrom für die elektrischen Elemente 10 zur Verfügung gestellt wird. Jedes Generatorelement 24 umfasst ein Peltierelement mit zwei z. B. quaderförmigen Elementen 24a, 24b je aus p- und n-dotierten Halbleitermaterial wie beispielsweise Bleitellurid, Bismuttellurid oder einem anderen Halbleitermaterial. Die Stromverbinder 26 verbinden jeweils das p-dotierte Element 24a eines Generatorelements 24 mit dem n-dotierten Element 24b eines benachbarten Generatorelements 24 bzw. umgekehrt. Durch die Inreiheschaltung der Generatorelemente 24 mithilfe der Stromverbinder 26 erzeugt jeder der beiden Thermogeneratoren 22 Beiträge zur Betriebsspannung der elektrischen Elemente 10 des Zünders 8. Die Thermogeneratoren 22 können in Reihe geschaltet sein, sodass jeder der beiden Thermogeneratoren 22 z.B. nur einen Teil der Betriebsspannung der elektrischen Elemente 10 erzeugt, z.B. jeweils zwischen 50 % und 60 %, oder parallel, sodass jeder der beiden Thermogeneratoren nur einen Teil des Betriebsstroms für die elektrischen Elemente erzeugt. Über Stromabgriffe 28 wird diese Betriebsspannung auf die elektrischen Elemente 10 übertragen.

Zwischen den beiden Thermogeneratoren 22 der Energieversorgungseinheit 20 ist eine Pyroeinheit 30 mit einem Brennelement 32 angeordnet. Das Brennelement 32 ist durch zwei Wärmespeicher 34 beidseitig umgeben, die jeweils zwischen dem Brennelement 32 und einem der Thermogeneratoren 22 angeordnet sind. Das Brennelement 32 enthält einen in einem Gehäuse angeordneten Feststoffbrennkörper, der nach einem Anzünden verbrennt und hierbei eine große Energiemenge als Wärme freisetzt. Diese Wärme wird über die beiden Wärmespeicher 34 auf die Heißseite 36 der Energieversorgungseinheit 20, genauer: Auf die jeweilige Heißseite 36 der beiden Thermogeneratoren 22, übertragen. Diese Heißseite 36 wird im Wesentlichen ausgefüllt durch eine Halteplatte 38, die die Wärme aus dem entsprechenden Wärmespeicher 34 übernimmt und über die Stromverbinder 26 oder direkt auf die Generatorelemente 24 überträgt. Auf der Kaltseite 40 der Thermogeneratoren 22 ist ebenfalls eine Halteplatte 42 angeordnet, die wie die Halteplatte 38 elektrisch isolierend und thermisch leitend ausgeführt ist. Mit der Kaltseite 40 thermisch verbunden ist jeweils ein Kältespeicher 44, wobei der in FIG 2 untere Kältespeicher 44 thermisch mit dem Boden 18 des Gehäuses 16 in Verbindung steht und der in FIG 2 obere Kältespeicher 44 mit einer Flugkörper-Außenwand 46 in thermischer Verbindung steht, sodass die Kältespeicher 44 an sie übertragene Wärme an den Boden 18 beziehungsweise die Zünderwand 46 übertragen.

Beim Ausführungsbeispiel aus FIG 2 sind die Generatorelemente 24 mittels Stromverbinder 26 elektrisch miteinander verbunden, z.B. durch Verlöten mit Weichlot. Anstelle von separaten Stromverbindern 26 ist auch denkbar und vorteilhaft, dass die Halteplatten 38, 42 selbst mit Stromverbindern ausgestattet sind, z.B. in Form von Leiterbahnen, die in die Halteplatten 38, 42 eingearbeitet sind. Die Generatorelemente 24 können dann unmittelbar mit den Halteplatten 38, 42 verbunden, z.B. verlötet, sein. Alternativ ist es möglich, dass die Halteplatten 38, 42 Lotaufnahmen haben, z.B. eine Metallschicht, die sich bereichsweise über die Halteplatten 38, 42 erstreckt, und die Stromverbinder 26 mit den Lotaufnahmen verlötet sind. Die Lotaufnahmen können Leiterbahnen sein.

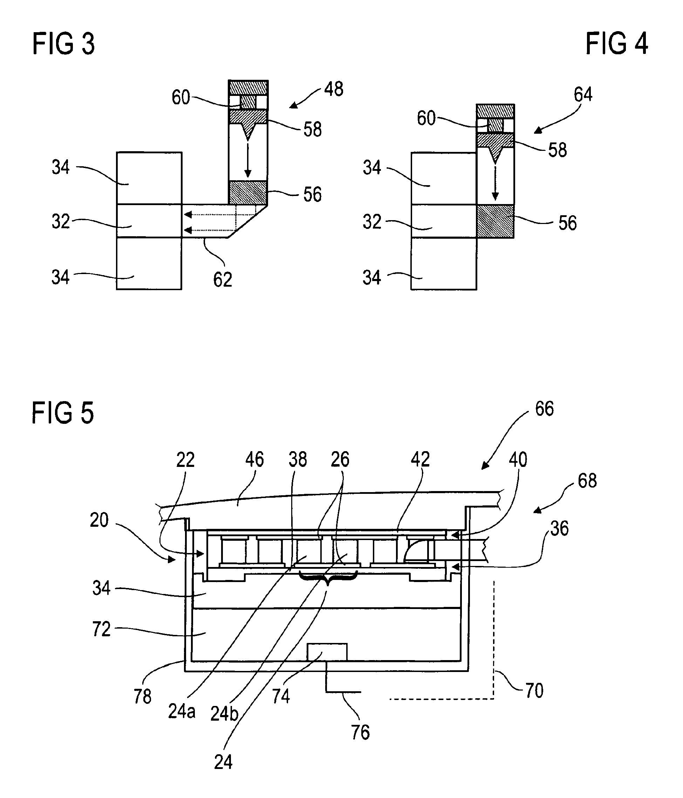

Beim Abschuss des Flugkörpers 2 aus einem Rohr wird ein Anzünder 48 (FIG 3) aktiviert und zündet das Brennelement 32 der Pyroeinheit 30 an. Innerhalb von wenigen Millisekunden brennt der gesamte Festbrennstoff des Brennelements 32 ab und setzt hierbei Wärme frei. Diese Wärme dringt an den Heißseiten der Wärmespeicher 34 in die Wärmespeicher 34 ein, durchtritt die Wärmespeicher 34 bis zu deren Kaltseite, die an der Heißseite 36 der entsprechenden Thermogeneratoren 22 anliegt. Die Halteplatte 38 und die heißseitigen Stromverbinder 26 heizen sich auf, sodass ein Temperaturgefälle über die Generatorelemente 24 entsteht. Aus diesem Temperaturgefälle erzeugen die Generatorelemente 24 eine Spannung, die mit wachsender Temperaturdifferenz zunimmt. Bei ausreichender Temperaturdifferenz liegt die Betriebsspannung der Elemente 10 vor, sodass diese über einen Zeitraum von etwa 90 s betrieben werden können.

Das Brennelement 32 ist als im Wesentlichen ebene Platte mit rundem Querschnitt ausgeführt, sodass die vom Brennelement 32 erzeugte Wärme großflächig auf die beiden Wärmespeicher 34 mit im Wesentlichem gleichen Querschnitt übertragen wird. Die erzeugte Wärme wird weitgehend von den beiden Wärmespeichern 34 aufgenommen, wobei diese sich erhitzen und durch die Energieabfuhr in die Generatorelemente 24 anschließend langsam wieder abkühlen. Um eine hohe Wärmespeicherfähigkeit und auch einen schnellen Wärmeübertrag von der Heißseite zur Kaltseite der Wärmespeicher 34 zu erreichen, sind diese aus Kupfer ausgeführt.

Trotz ihrer geringen Dicke von beispielsweise 1 mm benötigt die Wärme dennoch eine gewisse Weile, um in ausreichendem Maße zur Kaltseite der Wärmespeicher 34 zu gelangen, damit die für die Betriebsspannung notwendige Temperaturdifferenz an den Generatorelementen 24 erzeugt werden kann. Die Aufheizdauer bis zur Betriebstemperatur dauert z.B. einige 100 ms. Um diese Aufheizzeit der Kaltseite der Wärmespeicher 34 zu verkürzen, enthalten beide Wärmespeicher 34 an ihrer Heißseite Ausnehmungen 50 in Form von Vertiefungen, die mit Festbrennstoff des Brennelements 32 angefüllt sein können, wie durch die gestrichelte Linie in FIG 2 angedeutet ist, die den Umriss des Festbrennstoffs andeutet. An den tiefsten Stellen dieser Ausnehmungen 50 ist der Abstand zur Kaltseite des entsprechenden Wärmespeichers 34 weniger als die Hälfte des Abstands zwischen Heißseite und Kaltseite zwischen den Ausnehmungen 50. Hierdurch heizt sich die Kaltseite des betreffenden Wärmespeichers an den den Ausnehmungen 50 gegenüberliegenden Bereichen erheblich schneller auf, sodass dort die Betriebstemperatur - also die Temperatur, die zum Bereitstellen der Betriebsspannung notwendig ist - erheblich schneller erreicht wird. Um die Wärme von diesen heißen Bereichen möglichst gleichmäßig auf die Generatorelemente 24 zu verteilen, liegen diese heißen Bereiche unterhalb der Stromverbinder 26, insbesondere symmetrisch unter diesen, also symmetrisch zwischen p-dotiertem 24a und n-dotiertem Element 24b eines Generatorelements 24. Dadurch, dass die Ausnehmungen 50 relativ klein zum Gesamtvolumen des entsprechenden Wärmespeichers 34 ausgeführt sind, bleibt dem Wärmespeicher 34 immer noch eine hohe Wärmespeicherkapazität erhalten.

Brennelement 32 und Wärmespeicher 34 sind so ausgeführt und zueinander dimensioniert, dass die Spitzentemperatur an der Kaltseite der Wärmespeicher 34 und der Stromverbinder 26 300 °C überschreitet. Diese Temperatur ist kritisch für die Generatorelemente 24, die mit einem metallischen Weichlot mit den Stromverbindern 26 verbunden sind. Dieses Lot schmilzt bei so hohen Temperaturen, dass die feste Verbindung der Generatorelemente 24 mit ihren Stromverbindern 26 gelockert wird.

Um ein Zerfallen der Thermogeneratoren 22 zu verhindern, sind diese zwischen Wärmespeicher 34 und Kältespeicher 44, bzw. zwischen den Halteplatten 38, 42, eingeklemmt, also unter Druck gehalten. Hierdurch verbleiben die Generatorelemente 24 mit einer noch genügenden Reststabilität an ihrer Position, sodass die Stromerzeugung auch bei der großen Hitze noch genügend lang aufrechterhalten bleibt. Außerdem bilden die Generatorelemente 24 mit den Halteplatten 38, 42 einen ausreichend festen Verbund. Der Druck kann durch ein Druckelement 52 auf die Thermogeneratoren 22 ausgeübt werden, das bei dem in FIG 2 gezeigten Ausführungsbeispiel eine Tellerfeder ist. Es sind jedoch auch andere Druckelemente denkbar. Alternativ kann die Energieversorgungseinheit 20 mitsamt Kältespeichern 44 unter Druck im Gehäuse 16 gehalten sein, der beispielsweise durch ein Umbördeln der Seitenwände des Gehäuses 16 unter Spannung über einem Deckel erreicht wird.

Beim Abschuss des Flugkörpers 2 wirken hohe Beschleunigungskräfte auf den Flugkörper 2 und auch auf das Energieversorgungssystem 12, sodass diese mit mehreren 10.000 g, insbesondere bis 100.000 g, belastet wird. Um eine Zerstörung der Thermogeneratoren 22, insbesondere der Generatorelemente 24, zu verhindern, sind diese mit einem Haltematerial 54, beispielsweise einem Kunstharz, mit einer Haltestruktur, die in diesem Ausführungsbeispiel die Halteplatten 38, 42 umfasst, vergossen. Die Haltestruktur und die Generatorelemente 24 mit den Stromverbindern 26 bilden daher einen festen, monolithischen Block, der zwischen den Wärmespeicher 34 und dem Kältespeicher 44 eingeklemmt ist.

Ein Anzünder 48 zum Anzünden des Brennelements 32 ist in FIG 3 gezeigt. Der Anzünder 48 ist Teil der Pyroeinheit 30 und umfasst eine Zündladung 56 aus einem Festbrennstoff, der durch einen Anstich eines Anstichelements 58 leicht entzündet werden kann. Beim Abschuss des Flugkörpers 2 wird dieses nach vorne beschleunigt, sodass die Trägheit seiner Komponenten eine Kraft in Richtung des senkrechten Pfeils aus FIG 3 entgegen der Beschleunigungsrichtung bewirkt. Das Anstichelement 58 zerreißt bei der Abschussbeschleunigung durch seine Trägheit ein Halteelement 60, das das Anstichelement 58 in allen anderen Situationen fest am Platz hält. Das Anstichelement 58 wird durch seine Trägheit in Richtung des Pfeils auf die Zündladung 56 beschleunigt und bohrt seine Spitze in die Zündladung 56, sodass diese entzündet wird. Über einen Flammkanal 62 werden die heißen Verbrennungsgase auf das Brennelement 32 gelenkt, das dadurch seitlich entzündet wird. Das Brennelement brennt nun vollständig durch. Durch den Flammkanal 62 werden die in Axialrichtung ausgerichteten Flammen der Zündladung 56 umgelenkt und erreichen in Radialrichtung das Brennelement 32. Diese Anordnung hat den Vorteil, dass die Ausdehnungsebene des Brennelements 32 und der Wärmespeicher 34 senkrecht zur Abschussbeschleunigungsrichtung des Flugkörpers 2 ausgerichtet werden kann und hierdurch beim Abschuss eine akzeptable und homogene Belastung erfährt. Durch die Anordnung des Anzünders 48 seitlich vom Brennelement 32 kann die axiale Bauhöhe des Energieversorgungssystems 12 gering gehalten werden, sodass ihr Platzbedarf trotz der gewissen benötigten Flugstrecke des Anstichelements 58 bis zur Zündladung 56 vorteilhaft ist.

Eine alternative Form eines Anzünders 64 ist in FIG 4 dargestellt. Im Unterschied zum Ausführungsbeispiel aus FIG 3 wird auf den Flammkanal 62 und die Umlenkung der Flammen aus der Zündladung 56 verzichtet. Die Zündladung 56 ist direkt benachbart zum Brennelement 32 angeordnet und zündet dieses unmittelbar an.

FIG 5 zeigt einen Ausschnitt aus einem weiteren Flugkörper 66 in Form eines Geschosses, dessen Energieversorgungssystem 68 Teil eines nur angedeuteten Zünders 70 ist. Die nachfolgende Beschreibung beschränkt sich im Wesentlichen auf die Unterschiede zum Ausführungsbeispiel in den FIGen 1 und 2, auf das bezüglich gleich bleibender Merkmale und Funktionen verwiesen wird. Im Wesentlichen gleich bleibende Bauteile sind grundsätzlich mit den gleichen Bezugszeichen beziffert und nicht erwähnte Merkmale sind im folgenden Ausführungsbeispiel übernommen, ohne dass sie erneut beschrieben sind.

Das Energieversorgungssystem 68 umfasst nur einen einzigen Thermogenerator 22, der unmittelbar an der Zünderwand angeordnet ist, der - wie schon in FIG 2 - einen Teil der Geschosswand bzw. Flugkörper-Außenwand 46 bildet, sodass Umgebungsluft beim Flug des Geschosses 66 direkt an der Flugkörper-Außenwand 46 vorbeistreicht und diese kühlt. Die Flugkörper-Außenwand 46 dient dem Energieversorgungssystem 68 als Kältespeicher und ist zu diesem Zweck im Bereich des Energieversorgungssystems 68 dicker ausgeführt als in der Umgebung davon. Dies hat außerdem den Vorteil der leichteren Befestigung als bei gleichbleibender Wandstärke. Alternativ kann die Wand 46 in der Dicke gleichmäßig ausgeführt sein und ein zusätzliches, unmittelbar mit der Wand 46 verbundenes Element, das über die gesamte Fläche des Thermogenerators 22 an der Wand 46 anliegt, überträgt die Wärme aus der Thermogenerator 22 auf die Flugkörper-Außenwand 46.

In eine Pyroeinheit 72 ist ein Anzünder 74 eingebettet, der über eine Signalleitung 76 gezündet wird. Alternativ kann ein Anzünder 48, 64 wie vorhergehend beschrieben verwendet werden. Ein Gehäuse 78 des Energieversorgungssystems 68 schließt dieses nach außen ab und isoliert in der Weise nach außen, dass die Hitze der Pyroeinheit 72 nur in betriebserlaubter Menge durch das Gehäuse 78 dringt. Elektrische Elemente 10 des Geschosses, z.B. eines Suchkopfs, werden hierdurch nicht im Betrieb gestört.

Zur Stromerzeugung wird das Brennelement der Pyroeinheit 72 gezündet und gibt Wärme an den Wärmespeicher 34 ab, der die Wärme größtenteils an den Thermogenerator 22 mit den in Reihe geschalteten Generatorelementen 24 weitergibt. Der weitere Prozess ist zum vorhergehenden Ausführungsbeispiel beschrieben.

Die in den FIGen 2 und 5 gezeigten Ausführungsbeispiele sind so ähnlich, dass Elemente eines jeden Ausführungsbeispiels ohne weiteres in das andere Ausführungsbeispiel übernommen werden können, ohne den Rahmen der Erfindung zu verlassen. Beispielhaft kann hierfür die Verdickung der Flugkörper-Außenwand 46 im Bereich des Energieversorgungssystems 68 genannt werden, die selbstverständlich auch bei dem Energieversorgungssystem 12 möglich ist.

### Bezugszeichenliste

- 2: Flugkörper
- 4: Wirkladungsteil
- 6: Kopfteil
- 8: Zünder
- 10: Element
- 12: Energieversorgungssystem
- 14: Steuereinheit
- 16: Gehäuse
- 18: Boden
- 20: Energieversorgungseinheit
- 22: Thermogenerator
- 24: Generatorelement
- 24a: p-dotiertes Element
- 24b: n-dotiertes Element
- 26: Stromverbinder
- 28: Stromabgriff
- 30: Pyroeinheit
- 32: Brennelement
- 34: Wärmespeicher
- 36: Heißseite
- 38: Halteplatte
- 40: Kaltseite
- 42: Halteplatte
- 44: Kältespeicher
- 46: Flugkörper-Außenwand
- 48: Anzünder
- 50: Ausnehmung
- 52: Druckelement
- 54: Haltematerial
- 56: Zündladung
- 58: Anstichelement
- 60: Halteelement
- 62: Flammkanal
- 64: Anzünder
- 66: Flugkörper
- 68: Energieversorgungssystem
- 70: Zünder
- 72: Pyroeinheit
- 74: Anzünder
- 76: Signalleitung
- 78: Gehäuse

## Patentansprüche

1. Zünder (8, 70) eines Flugkörpers (2, 66) mit einem Energieversorgungssystem (12, 68), das eine Energieversorgungseinheit (20) mit zumindest einer Heißseite (36), zumindest einer Kaltseite (40) und zumindest einem zwischen den Seiten angeordneten Thermogenerator (22) aufweist,
**dadurch gekennzeichnet,**
**dass** die Energieversorgungseinheit (20) an ihrer zumindest einen Heißseite (36) eine Pyroeinheit (30, 72) zum Erzeugen von Wärme durch einen Verbrennungsprozess umfasst.

2. Zünder (8) nach Anspruch 1,
**dadurch gekennzeichnet,**
**dass** die Energieversorgungseinheit (20) zwei Thermogeneratoren (22) aufweist und die Pyroeinheit (30) zwischen den Thermogeneratoren (22) angeordnet ist.

3. Zünder (8, 70) nach Anspruch 1 oder 2,
**dadurch gekennzeichnet,**
**dass** die Pyroeinheit (30, 72) ein Brennelement (32) aufweist, das zumindest im Wesentlichen als ebene Platte ausgeführt ist.

4. Zünder (8, 70) nach einem der vorhergehenden Ansprüche,
**dadurch gekennzeichnet,**
**dass** zwischen dem zumindest einen Thermogenerator (22) und der Pyroeinheit (30, 72) ein Wärmespeicher (34) angeordnet ist.

5. Zünder (8, 70) nach Anspruch 4,
**dadurch gekennzeichnet,**
**dass** eine Dicke des Wärmespeichers (34) in Wärmeausbreitungsrichtung varüert.

6. Zünder (8) nach Anspruch 4 oder 5,
**dadurch gekennzeichnet,**
**dass** der Wärmespeicher (34) auf seiner der Pyroeinheit (30) zugewandten Seite Ausnehmungen (50) aufweist.

7. Zünder (8) nach Anspruch 6,
**dadurch gekennzeichnet,**
**dass** das oder die Generatorelemente (24) des zumindest einen Thermogenerators (22) an Zonen gegenüber von den Ausnehmungen (50) am Wärmespeicher (34) angeordnet sind.

8. Zünder (8, 70) nach einem der Ansprüche 4 bis 7,
**dadurch gekennzeichnet,**
**dass** die Pyroeinheit (30, 72) und der Wärmespeicher (34) so dimensioniert sind, dass der Wärmespeicher (34) an seiner Kaltseite nach Zünden der Pyroeinheit (30, 72) im regulären Betrieb zumindest kurzfristig bis auf eine Temperatur erhitzt wird, bei der eine Lotverbindung an dem oder den Generatorelementen (24) des zumindest einen Thermogenerators (22) schmilzt.

9. Zünder (8, 70) nach einem der vorhergehenden Ansprüche,
**dadurch gekennzeichnet,**
**dass** der zumindest eine Thermogenerator (22) ein oder mehrere Generatorelemente (24) aufweist, die in einer Haltestruktur mit einem Haltematerial (54) vergossen sind.

10. Zünder (8, 70) nach einem der vorhergehenden Ansprüche,
**dadurch gekennzeichnet,**
**dass** die zumindest eine Kaltseite (40) unmittelbar an einer Flugkörper-Außenwand (46) angeordnet ist.

11. Zünder (8, 70) nach einem der vorhergehenden Ansprüche,
**dadurch gekennzeichnet,**
**dass** eine Kaltseite (40) des zumindest einen Thermogenerators (22) an einem Kältespeicher (44) und dieser an einer Flugkörper-Außenwand (46) angeordnet ist.

12. Zünder (8, 70) nach einem der vorhergehenden Ansprüche,
**dadurch gekennzeichnet,**
**dass** die Pyroeinheit (30, 72) einen Brennstoff aufweist, dessen Durchbrenndauer maximal 2 % der Zeit beträgt, die die Energieversorgungseinheit (20) Strom zum Betrieb von elektrischen Einheiten (10) bereitstellt.

13. Zünder (8, 70) nach einem der vorhergehenden Ansprüche,
**dadurch gekennzeichnet,**
**dass** die Pyroeinheit (30, 72) einen Anzünder (48, 64, 74) aufweist, der zu einer Anstichzündung bei Abschuss des Flugkörpers (2) vorbereitet ist.

14. Zünder (8, 70) nach Anspruch 13,
**dadurch gekennzeichnet,**
**dass** der Anzünder (48, 64, 74) zu einem radialen Anzünden der Pyroeinheit (30, 72) mithilfe einer axialen Zündbeschleunigung eines Anstichelements (58) vorbereitet ist.

15. Verfahren zum Versorgen von elektrischen Elementen eines Zünders (8, 70) eines Flugkörpers (2) mit elektrischer Energie, bei dem zumindest eine Heißseite (36) einer Energieversorgungseinheit (20) eines Energieversorgungssystems (12, 68) erwärmt wird, zumindest ein Thermogenerator (22) der Energieversorgungseinheit (20) Strom erzeugt und dieser zu den elektrischen Elementen (10) geführt wird,
**dadurch gekennzeichnet,**
**dass** zum Erwärmen der Heißseite (36) ein Verbrennungsprozess einer Pyroeinheit (30, 72) der Energieversorgungseinheit (20) ausgelöst wird.
